Europäisches Patentamt

European Patent Office

Office européen des brevets

(19)

(11) Numéro de publication: **0 300 856**

**A1**

(12) **DEMANDE DE BREVET EUROPEEN**

(21) Numéro de dépôt: **88401617.1**

(22) Date de dépôt: **24.06.88**

(51) Int. Cl.⁴: **G 01 R 31/00**
G 07 C 5/10

(30) Priorité: **30.06.87 FR 8709232**

(43) Date de publication de la demande:
**25.01.89 Bulletin 89/04**

(84) Etats contractants désignés: **DE ES GB IT**

(71) Demandeur: **AUTOMOBILES PEUGEOT**
**75, avenue de la Grande Armée**
**F-75116 Paris (FR)**

**AUTOMOBILES CITROEN**
**62 Boulevard Victor-Hugo**
**F-92200 Neuilly-sur-Seine (FR)**

(72) Inventeur: **Celnik, Jean**
**40 Avenue d'Italie**
**F-75013 Paris (FR)**

**Le Guern, René**
**10, rue Jean Sébastien Bach**
**F-78340 Les Clayes-Sous-Bois (FR)**

(74) Mandataire: **Moncheny, Michel**
**c/o Cabinet Lavoix 2 Place d'Estienne d'Orves**
**F-75441 Paris Cedex 09 (FR)**

(54) **Dispositif et ensemble de test et d'aide au diagnostic d'une fonction remplie par un système électronique embarqué à bord d'un véhicule automobile et son procédé de mise en oeuvre.**

(57) Ce dispositif de test est caractérisé en ce qu'il comporte une unité centrale polyvalente (1), comprenant un ensemble à microprocesseur, un clavier (2) d'entrée d'informations, un dispositif (3) d'affichage d'informations, au moins une embase (4) de raccordement d'un cordon (5) de connexion de l'unité centrale (1) au véhicule, ledit cordon étant adapté au type du véhicule et à la fonction à tester, et deux ensembles de connexion (7,8) permettant le raccordement à l'unité centrale (1), d'une part d'un module interchangeable (9) contenant au moins un programme de test à effectuer par l'unité centrale (1) en fonction du type du véhicule et d'autre part, d'un module (10) d'interface interchangeable d'adaptation des entrées/sorties de l'unité centrale (1), à la fonction qu'il y a lieu de tester.

FIG.1

EP 0 300 856 A1

# Description

## Dispositif et ensemble de test et d'aide au diagnostic d'une fonction remplie par un système électronique embarqué à bord d'un véhicule automobile et son procédé de mise en oeuvre.

La présente invention concerne un dispositif et un ensemble de test et d'aide au diagnostic d'une fonction remplie par un système électronique embarqué à bord d'un véhicule automobile de type donné et un procédé de mise en oeuvre d'un tel ensemble.

On connait déjà dans l'état de la technique un certain nombre de dispositifs de ce type, permettant de localiser le ou les éléments en panne dans un véhicule présentant des anomalies de fonctionnement d'origine électronique.

Ainsi par exemple, on connait d'après le document FR-A-2 495 321, un procédé et un dispositif de diagnostic et de réparation de véhicule. Ce dispositif comprend un équipement de test et de diagnostic comportant des moyens destinés à connecter cet équipement au véhicule et des moyens destinés à mesurer les conditions de fonctionnement du véhicule, des moyens d'affichage, des moyens destinés à introduire dan les moyens d'affichage des données d'identification de véhicule particulières au véhicule considéré, des moyens d'enregistrement de base de données, cette base de données comprenant des spécifications pour des véhicules automobiles parmi lesquels figure le véhicule à réparer, des moyens destinés à sélectionner dans la base de données les données de spécifications particulières au véhicule considéré, conformément aux données d'identification de véhicule, et des moyens destinés à transférer les spécifications sélectionnées vers l'équipement de test et de diagnostic qui est connecté au véhicule, afin de lui permettre de réaliser le diagnostic.

On conçoit qu'un tel dispositif présente un certain nombre d'inconvénients notamment au niveau de l'infrastructure nécessaire pour sa mise en oeuvre, du temps nécessaire pour charger dans le dispositif de diagnostic les données de spécifications adaptées à un véhicule particulier, et de la structure de ces moyens de diagnostic qui doivent comporter un certain nombre de moyens permettant notamment d'interroger la base de données, de recevoir et de mémoriser les données transmises à partir de la base de données, d'assurer le test souhaité, et d'afficher les résultats correspondants.

Le but de l'invention est donc de résoudre ces problèmes en proposant un dispositif de test qui soit simple, fiable, qui puisse être adapté facilement et rapidement au type de véhicule considéré et à la fonction qu'il y a lieu de tester, qui puisse être embarqué à bord du véhicule et soit susceptible en outre de détecter les pannes fugitives sur véhicule roulant.

A cet effet, l'invention a pour objet un dispositif de test et d'aide au diagnostic d'une fonction remplie par un système électronique embarqué à bord d'un véhicule automobile de type donné, caractérisé en ce qu'il comporte une unité centrale polyvalente, comprenant un ensemble à microprocesseur, un clavier d'entrée d'informations, un dispositif d'affichage d'informations, au moins une embase de raccordement d'un cordon de connexion de l'unité centrale au véhicule, ledit cordon étant adapté au type du véhicule et à la fonction à tester, et deux ensembles de connexion permettant le raccordement à l'unité centrale d'une part d'un module interchangeable contenant au moins un programme de test à effectuer par l'unité centrale, en fonction du type du véhicule, et d'autre part, d'un module d'interface interchangeable d'adaptation des entrées/sorties de l'unité centrale, à la fonction qu'il y a lieu de tester.

Selon un autre aspect, l'invention a égale ment pour objet un ensemble de test et d'aide au diagnostic comportant un tel dispositif.

Selon encore un autre aspect, l'invention a également pour objet un procédé de mise en oeuvre d'un tel ensemble.

L'invention sera mieux comprise à l'aide de la description qui va suivre, donnée uniquement à titre d'exemple et faite en se référant aux dessins annexés, sur lesquels :

- la Fig.1 représente un schéma synoptique d'un dispositif selon l'invention;
- la Fig.2 représente un schéma synoptique d'une unité centrale entrant dans la constitution d'un dispositif selon l'invention; et
- la Fig.3 représente un schéma synoptique d'une carte interface pour test de système d'antiblocage de roue de véhicule, entrant dans la constitution d'un dispositif selon l'invention.

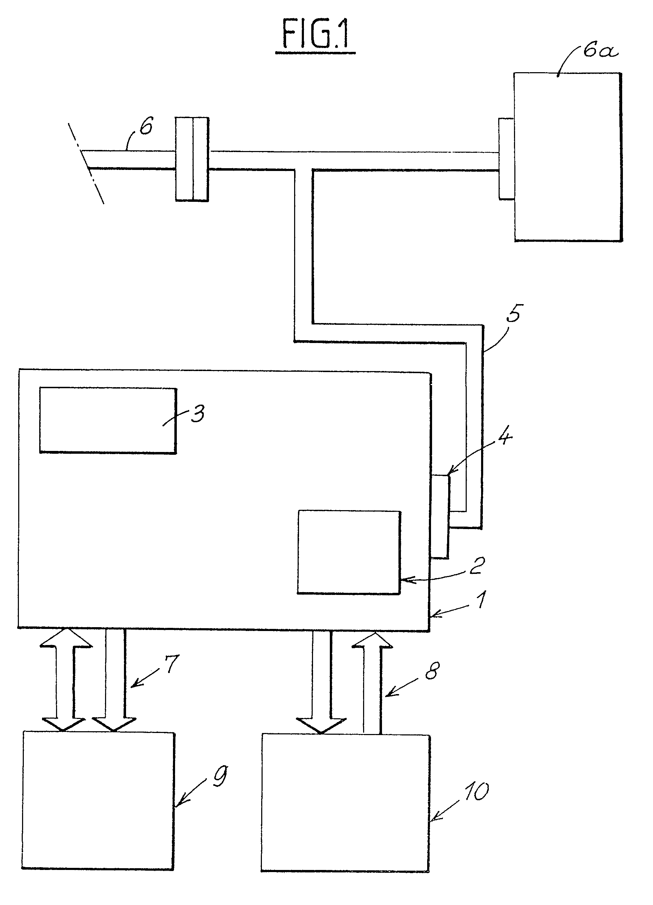

Ainsi qu'on peut le voir sur la Fig.1, le dispositif de test selon l'invention, comporte une unité centrale polyvalente 1 comprenant un ensemble à microprocesseur, un clavier d'entrée d'informations 2, un dispositif d'affichage d'informations 3 et au moins une embase 4 de raccordement d'un cordon 5 de connexion de l'unité centrale 1 au faisceau 6 du véhicule, ce faisceau étant relié lui-même aux différents organes électroniques du véhicule, tel que l'organe 6a.

Comme on le verra par la suite, ce cordon est adapté au type du véhicule et à la fonction qu'il y a lieu de tester.

L'unité centrale comporte également deux ensembles de connexion 7 et 8 permettant le raccordement à l'unité centrale 1, d'une part d'un module interchangeable 9 contenant au moins un programme de test à effectuer par l'unité centrale 1, en fonction du type du véhicule considéré, et d'autre part, d'un module d'interface 10. Ce module d'interface est également interchangeable et permet d'adapter les entrées/sorties de l'unité centrale 1, à la fonction qu'il y a lieu de tester.

Ainsi la conception de ce dispositif de test lui permet d'être utilisable pour la majorité des systèmes électroniques embarqués à bord des véhicules automobiles. Son caractère polyvalent est obtenu par la présence d'une partie commune à toutes les applications, cette partie commune étant constituée par l'unité centrale 1, l'ensemble à microprocesseur, le clavier 2 et les moyens d'affichage 3, et d'une partie spécifique à chaque application; cette partie spécifique étant constituée par la carte interface spécifique à chaque fonction à tester et comprenant des circuits électroniques bien connus d'interfaçage des entrées/sorties de l'unité centrale pour les diverses applications possibles, une carte programme contenant pour chaque type de véhicule associé à son année modèle, le programme de test qu'il y a lieu de réaliser, et un cordon de raccordement spécifique.

Ce dispositif est alors intégré dans un ensemble de test mis à la disposition des utilisateurs, par exemple des garagistes, et comprenant également un jeu de cordons de connexion, dont chacun est adapté à un type de véhicule et à une fonction donnée, un jeu de modules interchangeables contenant des programmes de test, dont chacun est adapté à un type donné de véhicule et un jeu de modules d'interface interchangeables dont chacun est adapté à une fonction qu'il y a lieu de tester. L'utilisateur sélectionne alors dans le jeu de cordons, un cordon adapté au type de véhicule et à la fonction qu'il y a lieu de tester, dans le jeu de modules de programme, le module adapté au type du véhicule, et dans le jeu de modules d'interface, le module adapté à la fonction à tester et connecte ces éléments à l'unité centrale et au véhicule avant d'effectuer les opérations de test.

Cette structure permet de dégager totalement le dispositif de test selon l'invention de toute base de données centrale et permet de simplifier le dispositif de test, dans la mesure où celui-ci ne comporte plus les différents moyens lui permettant de dialoguer avec la base de données centrale afin de recueillir les différentes informations nécessaires au test à effectuer. De plus, la mise en oeuvre de cet ensemble est extrêmement simple car il suffit à l'utilisateur de sélectionner les bons modules de programme et d'interface et le bon cordon pour réaliser le test et qu'il n'a plus à interroger une base de données centrale, avec tous les inconvénients que cela présente, pour charger dans l'unité centrale les données nécessaires au test.

L'ensemble des composants constituant l'unité centrale est implanté par exemple sur une seule carte de circuit imprimé.

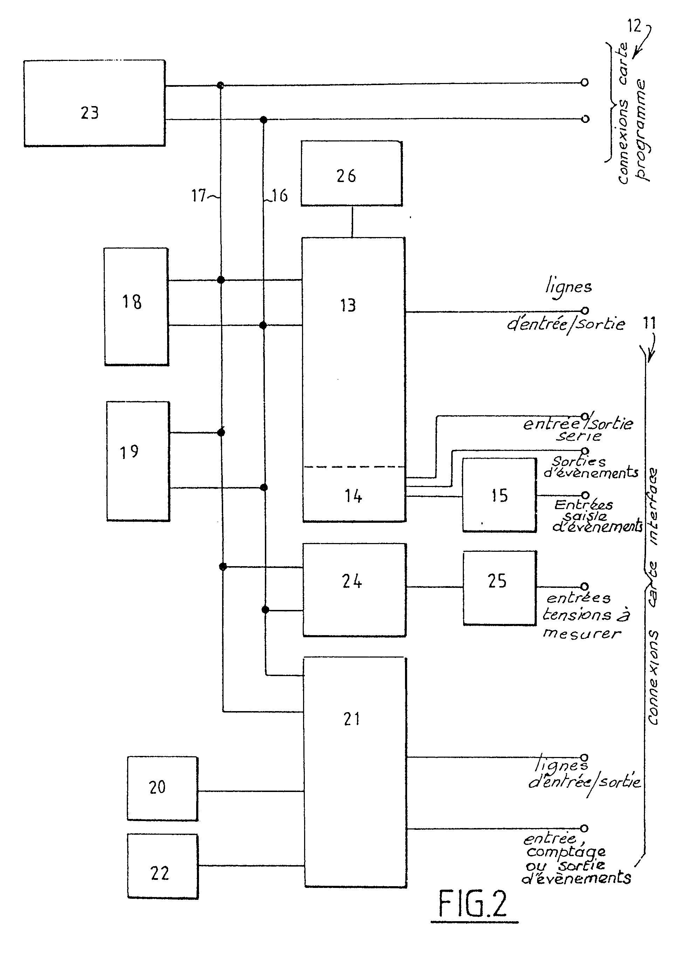

Cette unité centrale échange des informations avec la carte interface grâce à des connexions carte interface désignées de façon générale par la référence 11 sur la Fig.2, et avec la carte programme contenant le logiciel de l'application envisagée, qui contrôle les procédures de test, à travers des connexions de carte programme référencées par 12 sur cette figure.

L'unité centrale est bâtie autour d'un microprocesseur 13 comprenant un rythmeur intégré 14 facilitant le traitement en temps réel des informations. Ce rythmeur 14 permet en outre d'engendrer et de saisir des événements, à travers un multiplexeur logique 15 par exemple à huit voies. Ce microprocesseur est également relié à un bus d'adresses 16 et à un bus de données 17 destinés aux échanges d'informations avec le reste du dispositif.

L'unité centrale comporte également un certain nombre de mémoires dont une mémoire morte 18 qui contient le logiciel de base nécessaire à la gestion des différentes ressources du système (clavier, visualisation, etc ..) et des fonctions primitives pouvant être appelées par le logiciel de la carte programme comme par exemple les routines d'arithmétique, de mesure, etc. Cette mémoire contient également un programme d'auto-test de l'unité centrale qui s'exécute à chaque mise sous tension du dispositif.

L'unité centrale comporte également une mémoire volatile 19 par laquelle transitent les données momentanées. Les valeurs des enregistrements peuvent être stockées dans cette mémoire.

Par ailleurs, une mémoire vive non volatile 20 est également reliée à un composant périphérique d'interfaçage 21 lui-même relié aux bus d'adresses et de données 16 et 17 respectivement. Cette mémoire permet de sauvegarder, même hors tension, des informations telles que la configuration du système, le type de panne détectée, les défauts intermittents, etc.

Le composant périphérique d'interfaçage 21 est totalement programmable et possède plusieurs fonctions remplies par un premier port destiné aux échanges de données en parallèle avec la carte interface et un second port réservé au traitement interne au système et assurant une liaison avec la mémoire 20 et un clavier d'entrée de données 22.

Ce composant comporte également deux rythmeurs dont l'un possède une horloge de comptage extérieur et l'autre une sortie d'évènements. Une unité de sérialisation est également intégrée ainsi que des lignes de commande d'interruptions mémorisables.

L'unité centrale comporte également un module de visualisation 23 qui est raccordé sur les bus de données et d'adresses et échange des informations avec ceux-ci par exemple en code ASCII.

Les mesures analogiques sont assurées dans l'unité centrale par un convertisseur analogique-numérique 24 connecté à la sortie d'un multiplexeur analogique 25, les sorties du convertisseur 24 étant reliées aux bus d'adresses et de données.

Le bon déroulement des programmes est constamment vérifié par une logique de surveillance et d'initialisation 26 du type "chien de garde" et en cas d'anomalies une réinitialisation est effectuée.

Le module d'interface peut par exemple être constitué par une carte de test des systèmes d'antiblocage de roues. Cette carte contient alors l'ensemble des composants nécessaires au contrôle par exemple de trois systèmes d'antiblocage du type ABS Bosch, Antiskid Tevès et ABR Bendix.

Les systèmes d'antiblocage de roues, quel que soit leur type, comportent des capteurs de vitesse qui mesurent la vitesse de rotation des roues à chaque instant, une baisse de vitesse indiquant une tendance au blocage de la roue. Lorsqu'une baisse de vitesse est détectée, le système commande des électrovannes pour diminuer le freinage et donc éviter le blocage de la roue.

Ainsi, qu'il a été mentionné précédemment, seul le cordon de raccordement est spécifique à chacun de ces types de système et il est raccordé en parallèle sur le faisceau du véhicule. Deux modes de contrôle peuvent être effectués, soit véhicule à l'arrêt, soit véhicule roulant.

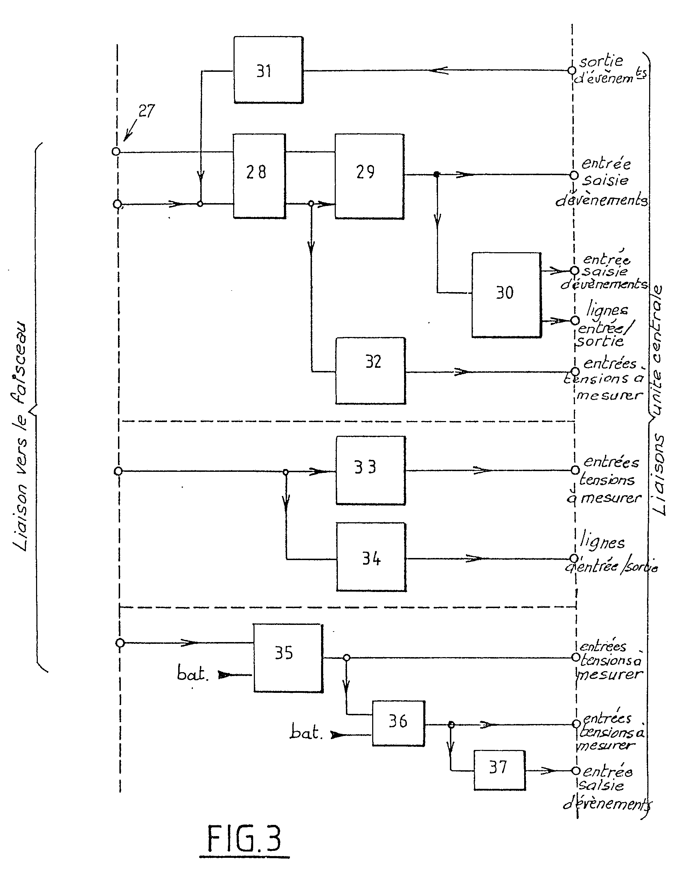

Comme on peut le voir sur la Fig.3 qui représente un schéma synoptique d'une carte interface pour une application aux systèmes d'antiblocage de roues et sur laquelle on a représenté une chaine d'acquisition pour un seul capteur, alors que ce type de système en comporte quatre, cette carte comporte trois parties principales :

1) Une partie concernant les capteurs :

Les signaux "capteur" sont prélevés en 27 sur le faisceau du véhicule et après un écrêtage dans des moyens d'écrêtage 28, par exemple de 0 volt à la tension de la batterie du véhicule, ces signaux sont mis en forme dans une bascule 29 par exemple du type "Trigger de Schmitt". Ces signaux sont ensuite envoyés aux entrées de saisie d'évènements de l'unité centrale à travers les moyens de connexion référencés en 11 sur la Fig.2. On peut ainsi mesurer les périodes des capteurs et détecter l'arrêt du véhicule.

Les signaux mis en forme sont également appliqués à des moyens de différenciation synchrone 30 dont la fonction est de permettre l'enregistrement d'une série de périodes consécutives simultanément sur les quatre capteurs.

Le dispositif permet au programme de test de contrôler la cohérence des signaux en roulant c'est à dire de détecter la présence de parasites.

Un générateur alternatif 31 permet d'injecter à travers les capteurs en place, des signaux de simulation à différentes vitesses et de simuler des baisses de vitesse c'est à dire des tendances au blocage sur une des roues. Cette fonction n'est autorisée qu'à l'arrêt du véhicule.

Les tensions "capteur" sont également mesurées en analogique à travers un multiplexeur 32 afin de détecter d'éventuelles tensions parasites et de contrôler la courbe de transfert des capteurs.

2) Une partie concernant les tensions statiques :

Des tensions statiques du type voyant ou alimentation de relais sont mesurées à travers un multiplexeur 33. Par la présence de charges à l'entrée, une rupture de liaison peut être détectée. Par ailleurs, des moyens 34 de mémorisation de tout changement d'état de ces entrées sont également prévus dans le dispositif et permettent de détecter une rupture fugitive lorsque le véhicule roule.

3) Une partie concernant les électrovannes :

Les tensions des électrovannes sont mesurées à travers un multiplexeur analogique 35, permettant d'étendre le nombre d'électrovannes à six pour les systèmes du type Tevès et Bendix et à trois pour le système Bosch. Ce multiplexeur comporte également une voie réservée à la mesure de la tension batterie. La tension d'une électrovanne est appliquée soit directement au convertisseur 24 de l'unité centrale à travers le multiplexeur 25, soit à des moyens de soustraction 36 recevant également la tension batterie afin de ne mesurer que la différence de tension vis à vis de celle-ce. Ceci est le cas par exemple pour les systèmes d'antiblocage Bosch et Bendix dont les électrovannes sont ramenées au plus de la batterie. Cette mesure de tension permet d'évaluer le courant circulant dans les bobines.

Par ailleurs, des moyens de comparaison de tension 37 permettent de fournir une synchronisation sur un seuil et la mesure de la largeur de créneaux de conduction.

Ainsi, des tests peuvent être effectués sur des véhicules roulants ou à l'arrêt. Sur un véhicule roulant, il est possible de détecter des pannes fugitives ou des défauts intermittents. Les défauts intermittents sont stockés dans la mémoire 20 et restitués ensuite aux moyens de visualisation 23. Il est à noter que ces défauts ne pourraient être décelés à l'arrêt.

L'invention peut également s'appliquer au contrôle d'autres fonctions, par exemple de l'allumage (transistorisé ou électronique intégral).

**Revendications**

1. Dispositif de test et d'aide au diagnostic d'une fonction remplie par un système électronique embarqué à bord d'un véhicule automobile de type donné, caractérisé en ce qu'il comporte une unité centrale polyvalente (1), comprenant un ensemble à microprocesseur (13), un clavier (2;22) d'entrée d'informations, un dispositif (3;23) d'affichage d'informations, au moins une embase (4) de raccordement d'un cordon (5) de connexion de l'unité centrale (1) au véhicule, ledit cordon étant adapté au type du véhicule et à la fonction à tester, et deux ensembles de connexion (7,8;11,12) permettant le raccordement à l'unité centrale (1), d'une part d'un module interchangeable (9) contenant au moins un programme de test à effectuer par l'unité centrale (1) en fonction du type du véhicule et d'autre part, d'un module (10) d'interface interchangeable d'adaptation des entrées/sorties de l'unité centrale (1), à la fonction qu'il y a lieu de tester.

2. Dispositif selon la revendication 1, caractérisé en ce que l'unité centrale (1) comporte des moyens de mémorisation (20) de défauts intermittents et de visualisation (23) de ces défauts.

3. Ensemble de test et d'aide au diagnostic d'une fonction remplie par un système électronique embarqué à bord d'un véhicule automobile, caractérisé en ce qu'il comporte un dispositif selon la revendication 1 ou 2, et un jeu de cordons (5) de connexion, dont chacun est adapté à un type de véhicule et à une fonction donnée.

4. Ensemble selon la revendication 3, caractérisé en ce qu'il comporte en outre un jeu de modules (9) interchangeables contenant des programmes de test, dont chacun est adapté à un type donné de véhicule.

5. Ensemble selon la revendication 3 ou 4, caractérisé en ce qu'il comporte en outre un jeu de modules d'interface interchangeables (10) dont chacun est adapté à une fonction qu'il y a lieu de tester.

6. Ensemble selon l'une quelconque des revendications 3 à 5, caractérisé en ce que le module d'interface est constitué par une carte interface de test de système d'antiblocage de roue et en ce qu'elle comporte des moyens (31) permettant d'injecter à travers les capteurs du système d'antiblocage, le véhicule étant à l'arrêt, des signaux de simulation de la rotation des roues.

7. Procédé de mise en oeuvre d'un ensemble selon les revendications 3 à 6, caractérisé en ce qu'on utilise une unité centrale polyvalente (1), comprenant un ensemble à microprocesseur (13), un clavier d'entrée d'informations (2:22), un dispositif d'affichage d'informations (3;23), au moins une embase (4) de raccordement d'un cordon (5) de connexion de l'unité centrale (1) au véhicule, on sélectionne dans le jeu de cordons, un cordon (5) adapté au type de véhicule considéré et à la fonction qu'il y a lieu de tester, on sélectionne dans le jeu de modules contenant des programmes, le module (9) adapté au type du véhicule, on sélectionne dans le jeu de modules d'interface, le module (10) adapté à la fonction à tester et on connecte ces éléments à l'unité centrale et au véhicule pour effectuer le test.

## FIG.1

0300856

FIG.2

0300856

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| P,X | EP-A-0 231 607 (ZALESKI) <br> * Colonne 4, ligne 52 - colonne 9, ligne 15; figures 1,2 * <br> --- | 1,7 | G 01 R  31/00 <br> G 07 C   5/10 |
| Y | EP-A-0 163 775 (ROBERT BOSCH) <br> * Page 6, ligne 3 - page 8, ligne 14; figures 1,2 * | 1 | |
| A | --- | 4,7 | |
| Y | GB-A-2 173 007 (FORD U.K.) <br> * Page 1, ligne 112 - page 2, ligne 5 * | 1 | |
| A | --- | 3,7 | |
| Y | DE-A-3 540 599 (F. PORSCHE AG) <br> * Colonne 4, ligne 48 - colonne 7, ligne 40; figures 1-5 * | 1 | |
| A | --- | 6,7 | |
| A | TECHNISCHES MESSEN, vol. 53, no. 4, avril 1986, pages 138-141, Munich, DE; P.-D. REIF: "Interaktive Messsysteme im Kraftfahrzeug" <br> * Page 138, colonne 2, ligne 1 - page 139, colonne 1, dernière ligne * <br> --- | 1,2,7 | |
| A | DE-A-3 136 998 (W. KUNTZ) <br> * Page 4, ligne 15 - page 5, ligne 5; figure 1 * <br> --- | 1,5 | |
| A | EP-A-0 217 774 (AB VOLVO) <br> * Page 1, ligne 12 - page 2, ligne 29; figure 1 * <br> ---                        -/- | 1,3,5 | |

DOMAINES TECHNIQUES
RECHERCHES (Int. Cl.4)

G 01 R  31/00
G 07 C   5/00

**Le présent rapport a été établi pour toutes les revendications**

| Lieu de la recherche | Date d'achèvement de la recherche | Examinateur |
|---|---|---|
| LA HAYE | 15-11-1988 | TRELEVEN C. |

EPO FORM 1503 03.82 (P0402)

Office européen
des brevets

## RAPPORT DE RECHERCHE EUROPEENNE

Numero de la demande

EP 88 40 1617

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 890 836 (McKENZIE) <br> * Colonne 2, ligne 33 - colonne 3, ligne 35; figures 1,2 * <br> --- | 3 | |
| A | IEEE INTERNATIONAL AUTOMATIC TESTING CONFERENCE, Dayton, Ohio, 12-14 octobre 1982, pages 36-40, IEEE; "J.B. KING: "Strategy for development of vehicle electronic systems diagnostics" <br> * Page 37, colonne 2, ligne 15 - page 38, colonne 1, ligne 20 * <br> --- | 4 | |
| A | US-A-4 320 506 (FARAZI et al.) <br> * Colonne 1, ligne 13 - colonne 2, ligne 14; figure 1 * <br> ----- | 6 | |

**DOMAINES TECHNIQUES RECHERCHES (Int. Cl.4)**

Le présent rapport a été établi pour toutes les revendications

| Lieu de la recherche | Date d'achèvement de la recherche | Examinateur |
|---|---|---|
| LA HAYE | 15-11-1988 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)